# EUROPEAN PATENT APPLICATION

(11) **EP 2 535 930 A1**
(43) Date of publication of application: **19.12.2012**
(21) Application number: 11170165.2
(22) Date of filing: 16.06.2011
(51) Int. Cl.: H01L 23/485

(54) **Semiconductor device with contact pad stack**

(71) Applicant: austriamicrosystems AG, 8141 Unterpremstätten (AT)
(72) Inventor: Rohracher, Karl, 8041 Graz (AT); Schrems, Martin, 8063 Eggersdorf (AT)
(74) Representative: Epping - Hermann - Fischer

(57) **Abstract**

The semiconductor device comprises a semiconductor body carrying a dielectric (3), in which an upper metal layer (21) and a lower metal layer are embedded. An opening (4) in the dielectric (3) uncovers an area (20) comprising a contact area (2). A plurality of vias (6) are arranged below a frame area (5) bordering the contact area (2) and connect the upper metal layer and the lower metal layer. The vias are arranged in such a fashion that any straight line (s1, s2, s3) starting from the portion of the dielectric that is present between the opening and the lower metal layer passes the upper metal layer, the lower metal layer or at least one of the vias. The vias thus stop the linear extension of a crack propagating in the dielectric (3) in any lateral direction.

## Description

In semiconductor technology it is common practice to arrange contact pads of semiconductor devices on a stack of metal layers and intermetal dielectric. The contact pad stack is liable to cracks occurring in the dielectric during a wire bonding process. A propagation of a crack through the intermetal dielectric may seriously damage the device.

US 7 385 297 B1 describes a bond pad stack of four metal layers, which are interconnected by vias. Vias between the two uppermost metal layers are not placed in a region below the bond pad, in order to prevent the occurrence of cracks in the dielectric during a wire bonding process and to allow the arrangement of active components under the bond pad.

It is an object of the invention to disclose a means for preventing the propagation of a crack that occurs in the dielectric under a contact area.

This object is achieved with the semiconductor device according to claim 1. Embodiments emerge from the dependent claims.

The semiconductor device comprises a semiconductor body and metal layers in a dielectric above a surface of the semiconductor body. An upper metal layer, which has a contact area, is located at a greater distance from the semiconductor body than a lower metal layer. The dielectric separates and covers the metal layers and is provided with an opening above the contact area. An area of the upper metal layer, which borders the contact area, will be referred to by the term frame area in the following. A plurality of vias are arranged below the frame area and connect the upper metal layer and the lower metal layer. The vias laterally surround a portion of the dielectric that is present between the opening and the lower metal layer, and the vias are arranged in such a fashion that any straight line starting from this portion passes the upper metal layer, the lower metal layer or at least one of the vias. This means that any straight line that is parallel to the upper and lower metal layers and traverses said portion of the dielectric is limited in both of its opposite directions by one of the vias. If a crack occurs in the dielectric below the opening, and the crack is supposed to propagate along a straight line through the dielectric, it will inevitably hit one of the vias and be stopped there. The vias thus limit the linear extension of such a crack in any lateral direction.

In an embodiment of the semiconductor device the vias are arranged in rows following a longitudinal direction that is transverse to any straight line that is parallel to the upper metal layer and traverses the portion of the dielectric between the opening and the lower metal layer. The vias succeed one another within the rows at distances forming a pattern that is the same for each of the rows. The rows are arranged beside each other with their longitudinal directions aligned. The patterns of neighbouring rows are shifted in the longitudinal direction relative to one another.

In a further embodiment of the semiconductor device the vias succeed one another within the rows at equal distances.

In a further embodiment there are at least five rows arranged beside each other with their longitudinal directions aligned.

In a further embodiment of the semiconductor device the opening is rectangular in a plan view, and the longitudinal directions of the rows are parallel to sides of the rectangle formed by the opening.

In a further embodiment of the semiconductor device the area of the upper metal layer that is uncovered by the opening is larger than the contact area and comprises a portion of the frame area below which the vias are arranged.

In a further embodiment of the semiconductor device none of the vias is arranged between the lower metal layer and the contact area.

In a further embodiment of the semiconductor device at least one further metal layer is arranged between the surface of the semiconductor body and the lower metal layer, and further vias connect the lower metal layer and the further metal layer.

In a further embodiment of the semiconductor device an electric connection is arranged on the contact area.

In embodiments of the semiconductor device the vias are arranged as a means for limiting the linear extension of a crack occurring in the portion of the dielectric that is present between the opening and the lower metal layer.

For a more complete understanding of the present invention, and the advantages thereof, reference is now made to the following descriptions of examples taken in conjunction with the accompanying drawings, in which:
Figure 1 shows a plan view of a section of an embodiment of the device.
Figure 2 shows a plan view of a section of a pattern of the arrangement of vias.
Figure 3 shows a cross-section of an embodiment of the device.
Figure 4 shows a schematic diagram of a plan view of a section of an embodiment of the device.

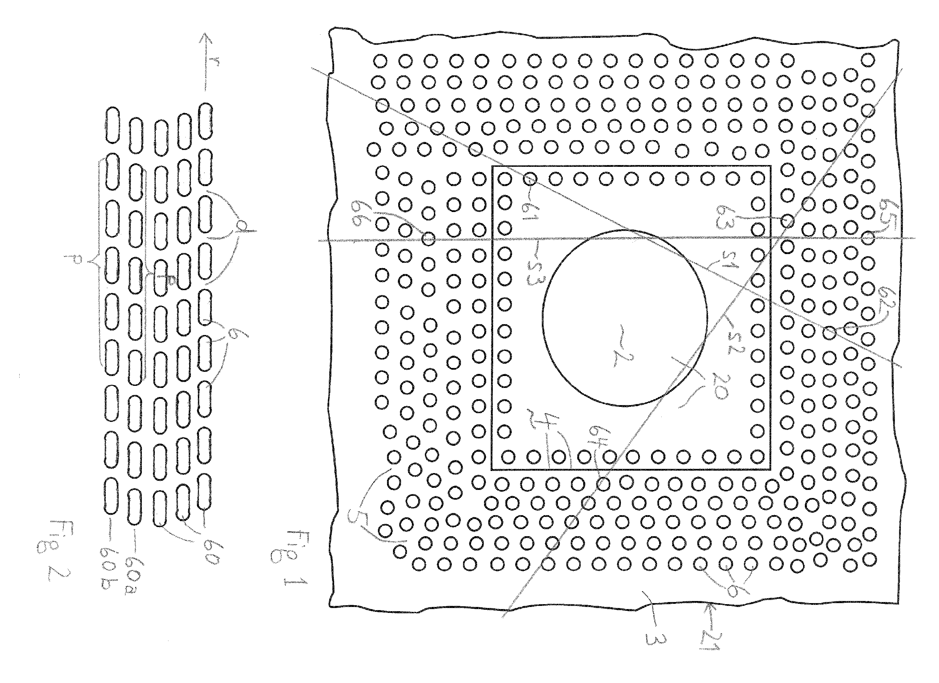

Figure 1 shows a plan view of a section of an embodiment of the semiconductor device. An upper metal layer 21 is covered by a dielectric 3, which comprises an opening 4 uncovering an area 20 of the upper metal layer 21. The uncovered area 20 comprises a contact area 2 where an external electric connection or terminal may be applied. The lateral contour of the opening 4 is shown in Figure 1 by a rectangle. The opening 4 is rectangular in this embodiment, but may have any other shape that is suitable to provide the contact area 2. A frame area 5 bordering the contact area 2 occupies a region of the upper metal layer 21 adjacent to the opening 4 and may also occupy a marginal section of the uncovered area 20 outside the contact area 2, as shown in the example of Figure 1. Below the frame area 5 a plurality of vias 6 are arranged between the upper metal layer 21 and the next lower metal layer of the stack. The vias 6 are represented in Figure 1 by small circles to indicate their positions, although the vias 6 are located behind the plane of the drawing of Figure 1, and their contours are hidden under the dielectric 3 and the upper metal layer 21. The vias 6 may be cylindrical, so that their cross-sections are circular as indicated in Figure 1. Instead, the corresponding cross-sections of the vias 6 may have any other suitable form and may particularly be elongated, especially elliptical or rectangular. The shapes of the vias 6 may also vary within the same embodiment. For example, the vias 6 may have the same or similar shapes in the vicinity of the contact area 2 and differ in locations that are remote from the contact area 2 or lie outside the region of the uncovered area 20.

In Figure 1 three imaginary straight lines s1, s2, s3 that are parallel to the upper metal layer 21 are represented by way of example. The straight lines s1, s2, s3 are supposed to traverse the dielectric 3 between the opening 4 and the next lower metal layer that is located under the upper metal layer 21. The straight lines s1, s2, s3 pass through vias 61 and 62, vias 63 and 64, and vias 65 and 66, respectively, and are thus limited in both directions. The vias 6 are arranged in such a manner that any straight line that traverses the dielectric 3 that is present below the upper metal layer 21 under the uncovered area 20 is limited in both directions by one of the metal layers of the stack or by one of the vias 6. For this purpose, the pattern of the arrangement of the vias 6 may have some feature of irregularity or modified regularity, which will be explained in the following.

Figure 2 shows a section of a schematic plan view of an example of a pattern that is suitable for the arrangement of the vias 6. In the embodiment according to Figure 2 the vias 6 are elongated in the shape of bars, but they may as well have other suitable shapes. The vias 6 are arranged in rows 60, in which the vias 6 succeed at distances d from one another. The succession of the vias 6 thus forms a pattern p along any of the rows 60. The patterns p may be periodic or non-periodic. The patterns p may be the same for each row 60, or they may be different. In the embodiment according to Figure 2 the patterns p are all equal, and the rows 60 are arranged side by side in such a manner that the patterns p of neighbouring rows 60a, 60b are shifted in the longitudinal direction r relative to one another. In the special example of Figure 2 the distances d are all equal and the patterns p are consequently periodic. If the vias 6 are elongated, it may be advantageous to arrange them in rows 60 according to their longitudinal extension, as shown in Figure 2.

The shift of the patterns p from row to row makes it impossible to draw a straight line transverse to the longitudinal direction r of the rows 60 in such a way that the straight line does not traverse any of the vias 6. In other words, there are no straight channels running in between the vias 6 transverse to the longitudinal direction r of the rows 60. The rows 60 may be straight and parallel to one another or, if they follow curved lines, neighbouring rows 60a, 60b may be spaced apart at a distance that is everywhere the same, so that the longitudinal directions r of the neighbouring rows 60a, 60b are everywhere aligned.

From the preceding description it is clear how the desired limitation of the linear propagation of a crack in the dielectric may be achieved by means of a slightly modified regular arrangement of the vias. Such an arrangement is easily designed and reproduced, and its application facilitates the manufacturing process. Figure 2 especially shows how an arrangement of only five rows 60 may suffice to achieve its purpose. In other embodiments the arrangement of the vias 6 may be more irregular. The degree of regularity of the arrangement of the vias 6 may also be varied between different locations within the same embodiment. Figures 1 and 2 give only two examples, which are intended to explain the basic idea of the invention without restricting its scope.

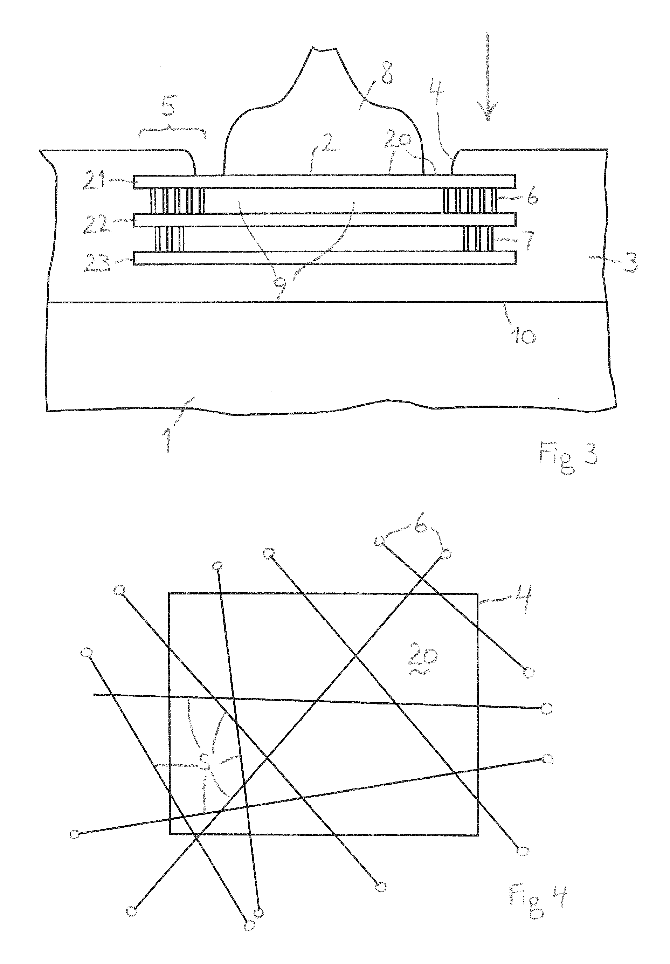

Figure 3 shows a section of a schematic cross-section of the embodiment of Figure 1. The arrow indicates the direction in which the plan view shown in Figure 1 is seen. The semiconductor body 1 has an upper surface 10 carrying the dielectric 3, which separates and covers the metal layers 21, 22, 23. The contact area 2 of the upper metal layer 21 is a section of the uncovered area 20 in the opening 4 of the dielectric 3. The vias 6 are arranged below the frame area 5 bordering the contact area 2. Cracks that may occur in the portion 9 of the dielectric 3 that is present between the opening 4 and the lower metal layer 22 are stopped at the upper metal layer 21, at the lower metal layer 22, or at one of the vias 6 that are arranged between these metal layers 21, 22 below the frame area 5.

A further metal layer 23 may be connected by further vias 7 to the lower metal layer 22. In other embodiments there may be further metal layers below the metal layers shown in Figure 3. Active and/or passive components of the device may be arranged below the contact area 2 within the semiconductor body 1. An electric connection 8, like a solder ball or bump, may be applied to the contact area 2. The electric connection 8 may fill the opening 4, or it may leave a section of the uncovered area 20 outside the contact area 2 free, as it is shown in the example of Figure 3.

Figure 4 shows a schematic diagram corresponding to the plan view of Figure 1. The uncovered area 20 is delimited by the contour of the opening 4. The straight lines s indicate various lines along which a crack may occur in the portion 9 of the dielectric 3 that is present between the opening 4 and the lower metal layer 22. Every straight line s is meant to be parallel to the upper metal layer 21 and is limited in both directions by vias 6. Irrespective of the choice of the straight line s, there is always a limit to a propagation of a crack in any one of the opposite directions that are defined by the straight line s. The arrangement of the vias 6 thus provides a means for limiting a portion 9 of the dielectric 3 below the uncovered area 20 laterally, and it consequently provides a means for stopping the linear propagation of a crack in any relevant direction. This arrangement thus improves the manufacturing process, because the risk of damages caused by process steps of probing or wire bonding will be drastically reduced, even if components are integrated under the contact pad stack.

### List of reference numerals

- 1: semiconductor body
- 2: contact area
- 3: dielectric
- 4: opening
- 5: frame area
- 6: via
- 7: further via
- 8: electric connection
- 9: portion of the dielectric
- 10: surface of the semiconductor body
- 20: uncovered area
- 21: upper metal layer
- 22: lower metal layer
- 23: further metal layer
- 60: row
- 61: via
- 62: via
- 63: via
- 64: via
- 65: via
- 66: via
- d: distance
- p: pattern
- r: longitudinal direction
- s: straight line
- s1: straight line
- s2: straight line
- s3: straight line

## Claims

1. Semiconductor device, comprising:
- a semiconductor body (1) having a surface (10),
- metal layers (21, 22, 23) located above the surface (10) and comprising an upper metal layer (21) and a lower metal layer (22), the upper metal layer (21) located at a greater distance from the semiconductor body (1) than the lower metal layer (22),
- a contact area (2) on the upper metal layer (21),
- a dielectric (3) separating and covering the metal layers (21, 22, 23),
- an opening (4) in the dielectric (3) above the contact area (2),
- a frame area (5) of the upper metal layer (21), the frame area (5) bordering the contact area (2), and
- a plurality of vias (6) arranged below the frame area (5) and connecting the upper metal layer (21) and the lower metal layer (22),
**characterized in that**
- the vias (6) are arranged as a means for limiting a portion (9) of the dielectric (3) that is present between the opening (4) and the lower metal layer (22) in such a fashion that any straight line (s) starting from the portion (9) of the dielectric (3) passes the upper metal layer (21), the lower metal layer (22) or at least one of the vias (6).

2. Semiconductor device according to claim 1, wherein the vias (6) are arranged in rows (60) following a longitudinal direction (r) that is transverse to any straight line (s) that is parallel to the upper metal layer (21) and traverses the portion (9) of the dielectric (3) between the opening (4) and the lower metal layer (22),
the vias (6) succeed one another within the rows (60) at distances (d) forming a pattern (p) that is the same for each of the rows (60), and
the rows (60) are arranged beside each other with their longitudinal directions (r) aligned, the patterns (p) of neighbouring ones of the rows (60a, 60b) shifted in the longitudinal direction (r) relative to one another.

3. Semiconductor device according to claim 2, wherein the vias (6) succeed one another within the rows (60) at equal distances (d).

4. Semiconductor device according to claim 2 or 3, wherein the rows (60) comprise at least five rows (60) arranged beside each other with their longitudinal directions (r) aligned.

5. Semiconductor device according to one of claims 2 to 4, wherein
the opening (4) is rectangular, and
the longitudinal directions (r) of the rows (60) are parallel to sides of a rectangle formed by the opening (4).

6. Semiconductor device according to one of claims 1 to 5, wherein
an area (20) of the upper metal layer (21) that is uncovered by the opening (4) is larger than the contact area (2) and comprises a portion of the frame area (5) below which the vias (6) are arranged.

7. Semiconductor device according to one of claims 1 to 6, wherein
none of the vias (6) is arranged between the lower metal layer (22) and the contact area (2).

8. Semiconductor device according to one of claims 1 to 7, further comprising:
at least one further metal layer (23) arranged between the surface (10) of the semiconductor body (1) and the lower metal layer (22), and
further vias (7) connecting the lower metal layer (22) and the further metal layer (23).

9. Semiconductor device according to one of claims 1 to 8, further comprising:
an electric connection (8) on the contact area (2).

10. Semiconductor device according to one of claims 1 to 9, wherein
the vias (6) are arranged as a means for limiting the linear extension of a crack occurring in the portion (9) of the dielectric (3) that is present between the opening (4) and the lower metal layer (22).
